(19) Europäisches Patentamt / European Patent Office / Office européen des brevets

(11) **EP 2 861 975 B1**

(12) **EUROPÄISCHE PATENTSCHRIFT**

(45) Veröffentlichungstag und Bekanntmachung des Hinweises auf die Patenterteilung:
**16.11.2016 Patentblatt 2016/46**

(21) Anmeldenummer: **13735028.6**

(22) Anmeldetag: **10.07.2013**

(51) Int Cl.:
***G01N 27/30*** *(2006.01)*

(86) Internationale Anmeldenummer:
**PCT/EP2013/064568**

(87) Internationale Veröffentlichungsnummer:
**WO 2014/016121 (30.01.2014 Gazette 2014/05)**

(54) **VERWENDUNG EINES REFERENZSYSTEMS FÜR ELEKTROCHEMISCHE ANALYSE- UND ABSCHEIDEVERFAHREN**

USE OF A REFERENCE SYSTEM FOR ELECTROCHEMICAL ANALYSIS AND DEPOSITION PROCEDURES

UTILISATION D'UN SYSTÈME DE RÉFÉRENCE POUR PROCÉDURES DE L'ANALYSE ÉLECTROCHIMIQUE ET SÉPARATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.07.2012 DE 102012106831**

(43) Veröffentlichungstag der Anmeldung:
**22.04.2015 Patentblatt 2015/17**

(73) Patentinhaber: **Ancosys GmbH**
**72124 Pliezhausen (DE)**

(72) Erfinder: **STAHL, Jürg**
**CH-8400 Winterthur (CH)**

(74) Vertreter: **Mammel und Maser**
**Patentanwälte**
**Tilsiter Straße 3**
**71065 Sindelfingen (DE)**

(56) Entgegenhaltungen:
EP-A2- 1 206 012      WO-A1-2012/019980
DE-A1- 4 329 742      US-A1- 2010 315 107

- **"Impedanzwandler für Einstabmessketten", JUMO Typenblatt 20.2995, 4. Mai 2009 (2009-05-04), Seiten 1-2, XP055078101, Fulda, Germany Gefunden im Internet: URL:http://www.jumo.de/attachments/JUMO/attachmentdownload?id=3792&filename=t20.2995de.pdf [gefunden am 2013-09-09]**
- **"Glasfreie Überlebenskünstler - Wartungsfreie pH-Messtechnik im Abwasser einer Betonproduktion", Austromatisierung, 1. Mai 2012 (2012-05-01), Seiten 74-75, XP055078092, Gefunden im Internet: URL:http://www.de.endress.com/ [gefunden am 2013-09-06] & "Ceramax CPS341D", Technische Information, 1. Juni 2010 (2010-06-01), Seiten 1-8, XP055078088, Gefunden im Internet: URL:http://www.de.endress.com/ [gefunden am 2013-09-06]**
- **Alan Ritch: "Shielding and Guarding", AN-347 APPLICATION NOTES, 1. Januar 1983 (1983-01-01), Seiten 1-6, XP055078080, Gefunden im Internet: URL:http://www.analog.com/static/imported-files/application_notes/41727248AN_347.pdf [gefunden am 2013-09-06]**
- **ANONYMOUS: 'LMP7721 3 Femtoampere Input Bias Current Precision Amplifier', [Online] 14 März 2008, XP055236562 Gefunden im Internet: <URL:http://www.farnell.com/datasheets/87421.pdf> [gefunden am 2015-12-15]**

**(Forts. nächste Seite)**

- **ANONYMOUS: 'LMP7715/LMP7716 Single and Dual Precision, 17 MHz, Low Noise, CMOS Input Amplifiers' 01 Mai 2006, Seiten 1 - 18, XP055236624**

**Beschreibung**

Die vorliegende Erfindung betrifft die Verwendung eines Referenzsystems für elektrochemische Analyse- und Abscheideverfahren, wobei bei den Verfahren wenigstens eine Arbeits-, eine Gegen- und eine Referenzelektrode eingesetzt werden.

In der elektrochemischen Analytik werden häufig Methoden eingesetzt, bei denen ein Referenzsystem Verwendung findet.

Solche Analysenmethoden sind beispielsweise stationäre Methoden wie Stromdichte-Potential-Messung, potentiostatische Messung und galvanostatische Messung, Potential-Sweep-Methoden wie Liner-Sweep-Voltammetrie LSV, zyklische Voltammetrie (Cyclovoltammetry) CV, Dreieckspannungsmethode (CyclovoltammetryStripping) CVS und Polarographie, Transient-Methoden wie Chronoamperometrie CA, Chronopotentiometrie CP, Chronocoulometrie CC und Kombinations-Methoden wie Spektroelektrochemie SEC oder elektrochemische Quarzmikrowaage EQCM und ortsaufgelöste Methoden wie Scanning Reference Electrode Technique SRET und Scanning Electochemical Microscope SECM, Wechselstrom-Methoden wie die elektrochemische Impedanzspektroskopie EIS oder Methoden ohne äußere Anregung wie Ruhepotential-Messung OCP und das elektrochemische Rauschen ECN.

Für bestimmte analytische Aufgaben können zwei oder mehrere Verfahren zu einer Methode kombiniert werden.

Weiterhin werden Referenzelektroden auch in elektrochemischen Produktionsverfahren wie der klassischen Beschichtungstechnik und der Halbleiterindustrie und der Leiterplattentechnik eingesetzt.

In der Halbleiterindustrie und Leiterplattenfertigung werden auch Beschichtungsverfahren mit schnellen Wechseln (weniger als 200 ms bzw. 100 ms) eingesetzt. So arbeitet beispielsweise das Puls-Plating-Verfahren mit Pulsen von < 100 ms. Auch bei dem sogenannten Hot-Entry-Verfahren, bei dem das zu beschichtende Gut kontrolliert eingefahren wird, spielen sich die Abläufe in weniger als 100 ms ab. Die Keimbildung, die für die Qualität einer Schicht entscheidend ist, erfolgt in weniger als 50 ms.

Zu den am weitesten verbreiteten Referenzelektroden gehören die Elektroden zweiter Art, deren Potential nur indirekt von der Konzentration der sie umgebenden Elektrolytlösung abhängt. Wichtige Elektroden zweiter Art sind die Silber-Silberchlorid-Elektrode und die Kalomel-Elektrode. Das Gleichgewichtspotential der Elektrode wird hierbei durch das Löslichkeitsprodukt des Bodenkörpers (z.B. schwerlösliches Salz oder Oxid) bestimmt. Eingesetzt werden sie beispielsweise in der Potentiometrie. Die Referenzsysteme dienen dazu, ein stabiles Bezugspotential in einer Flüssigkeit bereitzustellen.

Eine Anforderung an diese Systeme ist, dass bei geringen Stromdurchgängen das Elektrodenpotential unverändert bleiben soll.

Weiterhin muss die Impedanz der Referenzelektrode möglichst gering sein.

Selbstverständlich darf die zu untersuchende Flüssigkeit auch nicht durch das Referenzsystem verunreinigt oder beeinflusst werden, da dies zu einer Verfälschung des Messergebnisses führen würde.

Die bekannten Referenzsysteme stellen den elektrischen Kontakt zu der äußeren Flüssigkeit mittels eines inneren Elektrolyten (genau konzentrierte Alkalisalzlösung mit gleichem Anion wie das schwerlösliche Salz) über ein Diaphragma her.

Die Auswahl eines verträglichen inneren Elektrolyten für die bekannten Referenzsysteme ist schwierig, da der innere Elektrolyt sowohl mit der zu messenden Flüssigkeit als auch mit dem schwerlöslichen Salz der Referenzelektrode verträglich sein soll und zudem die Messungen auch nicht negativ beeinflussen darf.

Eine nicht optimale Auswahl des inneren Elektrolyten kann dazu führen, dass der elektrische Kontakt zwischen der Referenzelektrode und dem inneren Elektrolyten unterbrochen wird. Ein weiterer Nachteil der bekannten Referenzsysteme ist, dass die Elektroden wartungsintensiv sind, da Innen- oder Brückenelektrolyte regelmäßig nachgefüllt werden müssen. Häufig werden bei der Wartung auch Elektrolyte verwechselt oder verunreinigte Lösungen eingesetzt, eine weitere Fehlerquelle, die wiederum zur Verschiebung des Referenzpotentials und damit zu Fehlmessungen führt.

Das Diaphragma des inneren Elektrolyten kann auch unbrauchbar werden, beispielsweise wenn die zu untersuchende Flüssigkeit Ablagerungen am/im Diaphragma bildet.

Um die von Diaphragmen herrührenden Schwierigkeiten zu vermeiden, schlägt die DE 197 48 052 A1 einen Brückenkörper für eine Elektrode vor, wobei die Elektrode mit einem hochohmigen Eingang eines Operationsverstärkers verbunden sein kann. Bei dieser potentiometrischen Schaltung wird eine Messelektrode eingesetzt, die Elektrode mit dem Brückenkörper bildet die Gegenelektrode.

Der Einsatz von Referenzelektroden, die mit Quecksilber und Quecksilbersalzen aufgebaut sind, wird aus Gründen des Umweltschutzes immer weiter eingeschränkt.

Im Laborumfeld kann mit all diesen Schwierigkeiten noch umgegangen werden. Bei Anwendungen in der Online-Analytik und in Produktionsverfahren ist die Langzeitstabilität eines Referenzsystems jedoch äußerst wichtig, da hier kein Anwender oder Laborant zwischengeschaltet ist und es ohne äußeren Eingriff nicht möglich ist, festzustellen, ob sich das Potential der Referenzelektrode verändert hat und damit das gesamte Messergebnis verfälscht ist.

Aus der WO 2012/019980 A1 ist ein Referenzsystem mit einer pH-Elektrode als Referenzelektrode und einem Eingangsverstärker für die pH-Elektrode bekannt. Dieses Referenzsystem eignet sich jedoch nicht für schnelle Messungen.

Impedanzwandler für Einstabmessketten sind im Typenblatt 20.2995 der Firma JUMO beschrieben. Die EP 1 206 012 A1 lehrt Steckverbinder zum Anschluss einer Übertragungsleitung an mindestens einen Sensor. Die DE 43 29 742 A1 beschreibt eine Elektrode und Messanordnung mit einer Differenzverstärkerschaltung.

In AN-347 Application Notes vom 1. Januar 1983, Seiten 1-6 XP055078080 von Alan Rich "Shielding and Guarding" sind verschiedene Schirmungsschaltungen beschrieben.

Das Dokument "LMP7721 3 Femtoampere Input Bias Current Precision Amplifier" vom 14.03.2008 (XP055236562) beschreibt als Anwendungsbeispiel eine Verstärkerstufe für eine pH-Elektrode, wobei zur Vermeidung von Leckströmen der Signalleiter und die Kabelschirmung auf dem selben Potential gehalten werden.

Die Aufgabe der vorliegenden Erfindung besteht darin, ein Referenzsystem für elektrochemische Analyse- und Abscheideverfahren bereitzustellen, bei welchen Verfahren neben einer Arbeits- und einer Gegenelektrode auch eine Referenzelektrode eingesetzt wird, wobei das Referenzsystem die gewünschte Langzeitstabilität aufweisen, in der Online-Analytik auch für schnelle Messungen einsetzbar und zudem wartungsfreundlich sein soll.

Diese Aufgabe wird durch ein Referenzsystem mit den Merkmalen des Anspruchs 1 gelöst.

Durch die Verwendung einer pH-Elektrode, bei der der innere Elektrolyt durch eine Membran, die für die Messlösung undurchlässig ist, von der Messlösung getrennt ist, wird ein jeglicher Austausch von Ionen zwischen Messlösung und Innenelektrolyt verhindert, so dass unerwünschte

Änderungen des Bezugspotentials durch Verschmutzung oder Konzentrationsänderungen des Innenelektrolyten vermieden werden.

Nachdem sich an der undurchlässigen Membran nur ein Potential aufbaut, jedoch keine Teilchen hindurchtreten, kommt es auch nicht zu den von der Elektrode zweiter Art bekannten Verschmutzungen der Messlösungen und den beobachteten Ablagerungen an/in dem Diaphragma, die ebenfalls unerwünschte Potentialänderungen mit sich bringen.

Die Membran ist vorzugsweise eine Glasmembran.

Die pH-Elektrode ist vorzugsweise eine Glas- oder Emaille-Elektrode.

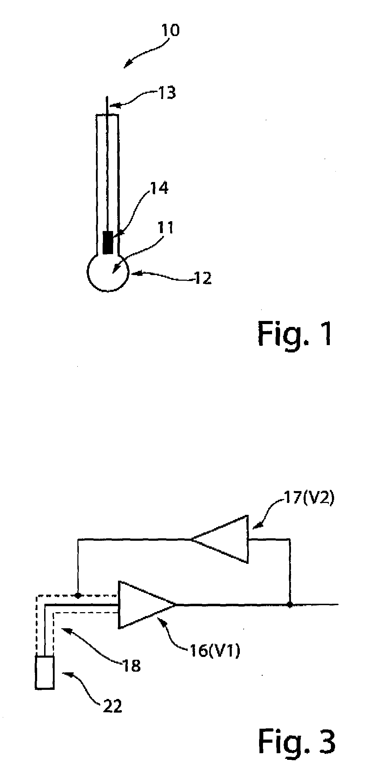

Unter einer Glaselektrode 10 im Sinne der vorliegenden Erfindung wird eine (einfache) Glaselektrode, bestehend aus einem Ableitsystem 14, einem elektrischen Anschluss 13 einem Innenpuffer/-elektrolyt 11 und einer Glasmembran 12 verstanden (vgl. **Figur 1**) und keine kombinierte Glaselektrode, d.h. keine Einstabmesskette mit Referenzelektrode. Der Innenpuffer/-elektrolyt steht bei der Glaselektrode in leitender Verbindung mit der Messlösung, an der das Potential entsteht. Die in der Glasmembran befindlichen Natrium- oder Lithiumionen sind relativ frei beweglich, für Wasserstoffionen ist die Membran hingegen undurchlässig.

Versuche haben darüber hinaus gezeigt, dass pH-Elektroden über lange Zeit ohne jegliche Wartung stabil sind. Die Abweichungen betrugen weniger als 5 mV, was mit klassischen Elektroden zweiter Art Ag/AgCl nicht erreicht wurde.

Ein weiterer Vorteil der pH-Elektrode mit undurchlässiger Membran besteht darin, dass das Gleichgewicht an der Membran im Falle von Systemstörungen aufgrund von hohen Spannungsdifferenzen oder Stromflüssen gestört wird und offensichtlich falsche Messwerte angezeigt werden. Der Benutzer hat somit eine Kontrollmöglichkeit der Funktionsuntüchtigkeit der pH-Elektrode. Bei den bekannten Referenzelektroden, insbesondere den Elektroden zweiter Art, treten bei hohen Spannungsdifferenzen und Stromflüssen jedoch nur schleichende, sich langsam verändernde Potentialänderungen auf, die häufig vom Benutzer nicht bemerkt werden und so mit einer defekten Elektrode weitergemessen wird.

Ein weiterer Vorteil der pH-Elektrode besteht darin, dass sich diese nach einer gewissen Zeitdauer und sachgerechter Lagerung auch nach hohen Spannungsdifferenzen oder Stromflüssen wieder erholt und somit nicht dauerhaft beschädigt wird.

Als pH-Elektrode kann ebenfalls beispielsweise eine Emaille-Elektrode eingesetzt werden, da diese ebenfalls eine undurchlässige Membran aufweist, durch die kein Ionendurchtritt erfolgt.

Aufgrund der pH-Abhängigkeit der pH-Elektrode ist es notwendig, den pH-Wert der zu messenden oder zu steuernden Flüssigkeit zu kennen oder aber bei Relativmessungen in Systemen mit konstantem oder sich in bekannter Weise veränderndem pH-Wert zu arbeiten.

Bei einer Glas-pH-Elektrode ist das gemessene Potential (gegen Wasserstoff 0) die Summe aus dem Potential, das sich an der Glasmembrane aufgrund des pH-Unterschiedes zwischen Innenelektrolyt und Messgut bildet und dem Potential, das durch das Ableitsystem gebildet wird. Eine handelsübliche Glas-pH-Elektrode hat einen Innenpuffer von pH 7 und ein Ag/AgCl-Ableitsystem.

Ein weiterer Vorteil des erfindungsgemäßen Referenzsystems besteht darin, dass für einen bestimmten pH-Wert durch geeignete Auswahl des Innenpuffers das Referenzsystem so einstellbar ist, dass die Temperaturabhängigkeit in der Nernst-Gleichung kompensiert wird. So können durch Temperaturänderungen bedingte Messfehler ohne zusätzliche Temperaturkontrolle beseitigt werden.

Die auf eine pH sensitive Membran angewandte Nernst-Gleichung lautet:

$$U_{pH} = (R*T)/F*\ln(C_x/C_0) \tag{1}$$

R= 8,31447 J mol$^{-1}$ K$^{-1}$ Gaskonstante, T= Temperatur [K], F = Faraday Konstante 96485,3 J V$^{-1}$ mol$^{-1}$

Formt man die Gleichung um, so erhält man:

$$U_{pH} = 0.198*T *(pH_0-pH_x) \qquad [mV] \tag{2}$$

pHo = pH Wert des Innenpuffers, pH$_x$ = pH Wert der Messlösung

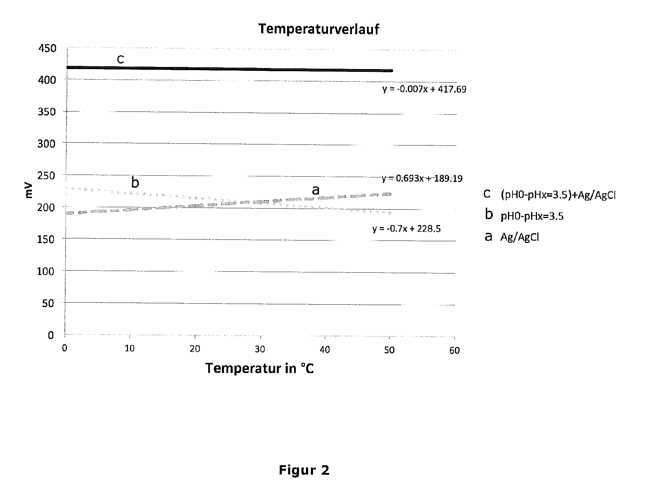

Aus der obigen Gleichung geht hervor, dass die Glasmembran einen Temperaturgang von 0,198 mV pro °C und pro pH-Unterschied zwischen H$^+$-Konzentration von Messgut und Innenpuffer hat. Der Temperaturgang für die Glasmembran ist in **Figur 2,** Kurve b dargestellt.

Für das Ableitsystem Ag/AgCl lautet die Nernst-Gleichung hingegen:

$$U_A = U_0+(R*T)/F*\ln(C_x/C_0) \tag{3}$$

mit Uo= Standardelektronenpotential.

Die genaue Berechnung der Temperaturabhängigkeit des Ableitsystems ist nicht exakt möglich. Messungen von Ableitsystemen in der Praxis haben einen Temperaturgang von -0,7 mV pro °C ergeben, vgl. Kurve a in Figur 2.

Da der Temperaturgang der pH Membrane positiv ist und der Temperaturgang des Ag/AgCl Ableitsystems negativ, kann bei geeigneter Wahl des Innenpuffers die Temperaturabhängigkeit der Referenzelektrode eliminiert werden.

Die Messspannung ist die Summe der Spannung, die an der pH Membrane entsteht und der Spannung des Ableitsystems (vgl. Figur 2 c).

Wählt man den Innenpuffer um 3,5 pH Einheiten über dem Wert des Messgutes, so beträgt die Temperaturabhängigkeit der pH Membran

$$U_{pH} = 0.198*T *(pH_0-pH_x) = T*0.198*3.5 = T*0.693 \; [mV] \tag{4}$$

Selbst wenn der pH-Wert eine Schwankung von +/-1 pH aufweist, hat man eine Temperaturabhängigkeit von maximal +/- 0,2 mV/°C. Damit kann in den meisten Anwendungen auf eine Temperaturmessung für die Kompensation der Referenzelektrode verzichtet werden.

Die Impedanzen von pH-Elektroden liegen typischerweise zwischen $5*10^6 \, \Omega$ und $1*10^9 \, \Omega$ und damit um Größenordnungen über den Impedanzen der Elektroden zweiter Art, die zwischen $1*10^3$ bis $0,1*10^6 \Omega$ betragen. Für einen stabilen Messaufbau ist eine Abschirmung des Messsystems notwendig, um Störungen von außen zu verhindern und zuverlässige Messungen zu gewährleisten. Bedingt durch den Aufbau einer Abschirmung bilden sich parasitäre Kondensatoren, die bis zu einigen hunderten Picofarad erreichen können. Diese parasitären Kondensatoren bilden zusammen mit der Impedanz der pH-Elektrode einen Tiefpass, der das Messsignal erheblich verzögert.

Dies führt dazu, dass pH-Elektroden nur zur Beobachtung oder Steuerung von langsamen oder statischen Vorgängen, die im Bereich von Sekunden verlaufen, eingesetzt werden können.

Um die gewünschte Langzeitstabilität des Potentials zu gewährleisten und das Referenzsystem auch für schnelle Online-Messungen, insbesondere dynamische Messungen mit Sweeps oder Pulsen, einsetzen zu können, ist es erfindungsgemäß weiterhin erforderlich, einen Eingangsverstärker V1 für die Referenzelektrode mit einer hohen Eingangsimpedanz vorzusehen und einen weiteren Verstärker V2, der die Effekte der Abschirmung und des Messaufbaus kompensiert.

Im Rahmen der vorliegenden Erfindung wird unter einem Verstärker V1 ein jegliches Bauteil oder eine Gruppe von Bauteilen mit einer hohen Eingangsimpedanz für die Referenzelektrode verstanden und unter dem weiteren Verstärker V2 ein jegliches Bauteil oder eine Gruppe von Bauteilen, die die Effekte der Abschirmung, des Kabels und/oder des Messaufbaus kompensiert oder im Wesentlichen kompensiert. Die Verstärker V1 und V2 können auch mit einem Verstärker realisiert werden.

Typischerweise sind Eingangsimpedanzen des Eingangsverstärkers V1 von wenigstens $10^{11} \, \Omega$ und vorzugsweise um mehr als $10^{12} \, \Omega$ erforderlich, um eine Belastung der Spannungsquelle zu vermeiden, die zu Verfälschungen der Spannungsmessung führen.

Geeignete Eingangsverstärker V1 benötigen einen Eingangsstrom, der kleiner als 10 pA, vorzugsweise kleiner als 1 pA und besonders bevorzugt kleiner als 200 fA, ist. Dies erlaubt eine exakte Messung des Potentials mit einer pH-Elektrode mit einer Impedanz von $1*10^9$ Ω.

Unter Abschirmung ist jede Maßnahme zu verstehen, die das Einkoppeln oder Abstrahlen von elektrischen Signalen auf das Signal der Referenzelektrode verhindert. Dazu gehören insbesondere Kabel, Ableitsystem in der Referenzelektrode, Verbindungstecker, Leiterbahnen auf der Leiterplatte und Gehäuse.

Jegliche kapazitive Belastung, die durch die Konstruktion der Referenzelektrode und den dazugehörenden Messaufbau bedingt sind, wirken sich nachteilig auf das Messen von schnellen Vorgängen aus. Die hohe Impedanz einer Referenzelektrode mit einer undurchlässigen Membran bildet mit jeder parasitären Kapazität einen Tiefpass, der das Messsignal verzögert. Die Impedanz einer Referenzelektrode mit einer undurchlässigen Membran hat typischerweise einen Wert von einigen $10^6$ Ohm bis $1 * 10^9$ Ohm. Weisen die parasitären Kapazitäten zusammen 100 pF auf und beträgt die Impedanz der Referenzelektrode $100*10^6$ Ohm, so beträgt die Verzögerungszeit 50 ms. Typischerweise sind die Zuleitungen zu dem Messverstärker V1 abzuschirmen. Die Abschirmung ist notwendig, um sicherzustellen, dass keine Störsignale in das Messsignal eingekoppelt werden. Die in der Praxis typischerweise verwendenden Koaxialkabel weisen eine kapazitive Belastung von 50 pF/m bis 100 pF/m auf. Diese kapazitive Belastung durch das Zuleitungskabel ist in der Regel mehr als 50 % der gesamten parasitären Belastung des Messsignales. Weist die Referenzelektrode eine Abschirmung des Ableitsystems auf, so weist dies typischerweise auch eine parasitäre Kapazität von bis zu 30 pF auf. Die verwendeten Stecker und Leiterplatten so wie der Verstärker V1 haben auch parasitäre Kapazitäten, die in der Regel <10 pF sind.

Um Messungen mit Signalverläufen von <200 ms zuverlässig zu machen, sind möglichst alle parasitären Kapazitäten, die ein Messaufbau aufweist, zu kompensieren. Dazu gehören insbesondere das Messkabel und die Abschirmung des Ableitsystems in der Referenzelektrode.Die verwendete Schaltung bestehend aus V1 und V2 ist in der Lage, den negativen Effekt der parasitären Kapazität zu eliminieren und trotzdem eine effektive Abschirmung zu gewährleisen. Normalerweise wird die Abschirmung (Kabel, Ableitsystem und Leiterplatte) auf Erde oder Masse des Maßsystems gelegt. Das heißt, dass alle parasitären Kapazitäten auf das Spannungspotential der Referenzelektrode aufgeladen werden müssen. Der notwendige Strom, der zum Aufladen der Kapazitäten benötigt wird, verursacht am Innenwiderstand der Referenzelektrode einen Spannungsabfall. Die gemessene Spannung ist immer kleiner als die von der Referenzelektrode erzeugte Spannung, solange ein Strom fliest, der benötigt wird, um die parasitären Kondensatoren der Abschirmung aufzuladen. Dieser Aufladevorgang kann eliminiert werden, wenn die Abschirmung an den Ausgang der Verstärkers V2 angeschlossen wird. Dadurch wird die Spannungsdifferenz zwischen dem Messsignal und der Abschirmung auf praktisch 0 V gehalten. Dadurch fließt kein Strom, und es entsteht kein Spannungsabfall am Innenwiderstand der Referenzelektrode. Voraussetzung für diese Art der Kompensation der parasitären Kapazitäten ist, dass die Spannung an der Abschirmung und des Messsignales eine möglichst kleine zeitliche Verzögerung aufweisen.

Vorzugsweise sollte die Grenzfrequenz des Eingangsverstärkers V1 mehr als 1 MHz, bevorzugt mehr als 3,5 MHz und besonders bevorzugt mehr als 25 MHz, betragen.

Der weitere Verstärker V2 muss in der Lage sein, die kapazitive Last der Abschirmung zu treiben, ohne das Signal zu verfälschen.

Das Potential darf nicht durch kapazitive Umladungen an den Zuleitungen der Elektrode und innerhalb des Messverstärkers verfälscht werden. Dies wird verhindert, indem das Potential der Abschirmung niederohmig auf exakt gleichem Potential wie das hochohmige Signal der pH-Elektrode gehalten wird.

Der weitere Verstärker V2 sollte eine Grenzfrequenz von wenigstens 1 MHz, vorzugsweise wenigstens 3,5 MHz und besonders bevorzugt wenigstens 25 MHz aufweisen und eine kapazitive Last von wenigstens 10 pF, vorzugsweise von wenigstens 100 pF und besonders bevorzugt von mehr als 1 nF treiben können.

Besonders gute Ergebnisse wurden mit pH-Glas-Elektroden mit integrierten Verstärkern und einer Abschirmung des Ableitsystems erzielt. Ebenfalls eignen sich ionensensitive Feldeffekttransistoren (ISFET-Elektroden oder REFET-Elektroden).

Da bei den meisten oben aufgeführten Anwendungen der pH-Wert der zu messenden Flüssigkeit während der Messung annähernd konstant bleibt, wird auch das Potential der hier beschriebenen Elektrode während der Messung nur vernachlässigbar beeinflusst.

Bei Online-Messungen und Produktionsverfahren sind die pH-Werte sehr stabil, da die Prozessfenster meistens eine Bandbreite von +/- <0,1 pH haben. Dies würde einer Referenzpotentialschwankung von +/- 5,9 mV entsprechen, was auch bei einem klassischen Referenzsystem zu erwarten ist. Sind größere Schwankungen zu erwarten, ist es notwendig, den pH-Wert zu kennen und entsprechend auf einen definierten Wert zu korrigieren. Sehr häufig wird die Konzentration der den pH-Wert bestimmenden Substanz im Zuge der Prozessüberwachung gemessen und nachgeregelt.

In **Fig. 3** ist das erfindungsgemäße Referenzsystem, das die Referenzelektrode 22, eine pH-Elektrode, den Eingangsverstärker 16 (V1) (Verstärkungsfaktor: 1x), den weiteren Verstärker 17 (V2) (Verstärkungsfaktor 1x), und die Abschirmung (Guarding) 18 umfasst, vereinfacht dargestellt. Der Eingangsverstärker 16 (V1) (Impedanzwandler) weist einen Eingangsstrom von weniger als 1 pA, vorzugsweise von weniger als 200 fA auf. Dies erlaubt eine exakte Messung des Potentials mit einer pH-Elektrode mit einer Impedanz von $1*10^9$ Ω. Der Verstärker 16 (V1) sollte auch noch eine Grenzfrequenz von mehr als 3,5 MHz, vorzugsweise von mehr als 25 MHz, aufweisen.

Der weitere Verstärker 17 (V2) ist ein Guard-Verstärker, der die parasitären Effekte der Abschirmung kompensiert. Die Abschirmung ist vereinfacht dargestellt. Die Abschirmung kann folgende Teile umfassen: Das Kabel, die Stecker, die Leiterplatte, die Verstärkergehäuse und den Schaft der Elektrode. Dies erlaubt es, auch schnelle Potentialveränderungen zu messen.

Der weitere Verstärker 17 (V2) muss in der Lage sein, die kapazitive Last der Abschirmung zu treiben. Der Verstärker 17 (V2) sollte eine Grenzfrequenz von mehr als 3,5 MHz und vorzugsweise von mehr als 25 MHz aufweisen und eine kapazitive Last von mehr als 100 pF, vorzugsweise von mehr als 1 nF treiben können.

Die Verstärker 16 (V1) und 17 (V2) können auch mit einem Verstärker realisiert werden. Die durch den Aufbau bedingten Streukapazitäten, die nicht von der Guardschaltung, d.h. dem Verstärker 16 (V1), dem Verstärker 17 (V2) und der Abschirmung kompensiert werden können, sollten weniger als 1 % der Kapazität betragen.

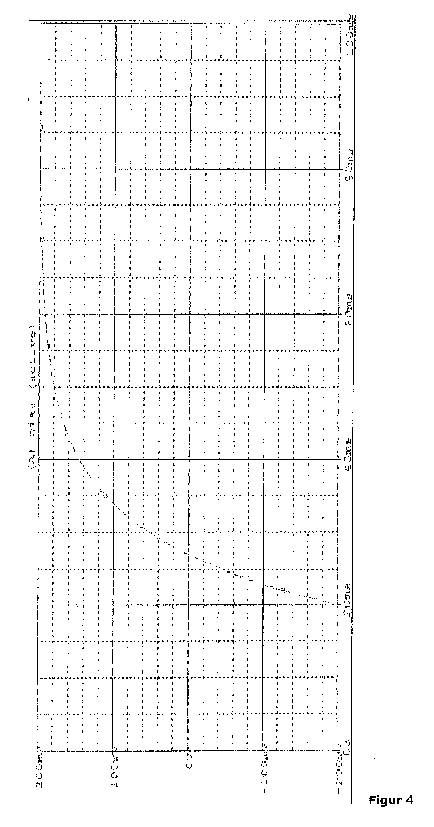

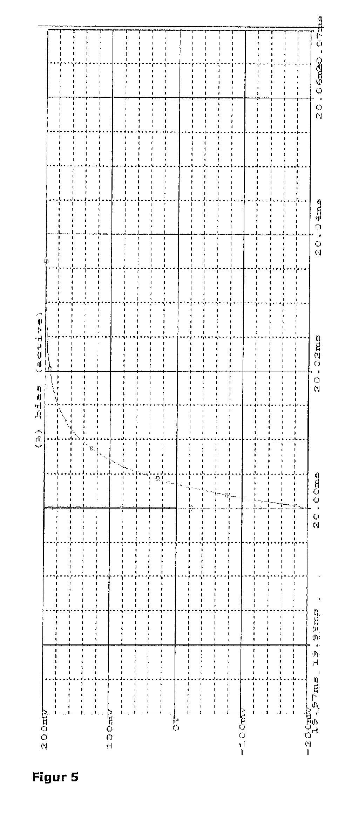

**Fig. 4** stellt eine Sprungantwort ohne Guardschaltung dar. Es dauert rund 80 ms, bis das impedanzgewandelte Signal dem tatsächlichen Signal folgen kann. In **Fig. 5** ist dieselbe Versuchsanordnung wie in **Fig. 4** dargestellt, aber mit einer optimal ausgelegten Guardschaltung (Abschirmung und Aufbau sowie einem optimierten Guardverstärker V2). Bei dieser Anordnung braucht das impedanzgewandelte Signal 50 μs, um dem tatsächlichen Signal zu folgen.

In der Messung wurde eine pH-Elektrode mit ca. 100 MΩ und einer totalen Guardkapazität von ca. 100 pF verwendet. Mit dieser Anordnung lassen sich Signale von deutlich weniger als 0,5 ms sehr zuverlässig und genau messen. Können die Impedanz der Elektrode und die Guardkapazitäten verringert werden, können noch wesentlich schnellere Signale gemessen werden.

Die in Figur 3 beschriebene Messanordnung aus pH-Elektrode 15, Eingangsverstärker (Impedanzwandler) 16 und weiterem Verstärker (Guardverstärker) 17 kann auch bei Anordnungen von drei oder mehr Elektroden zusammen mit potentiostatischen, galvanostatischen, dynamischen oder impedanzspektroskopischen Verfahren eingesetzt werden.

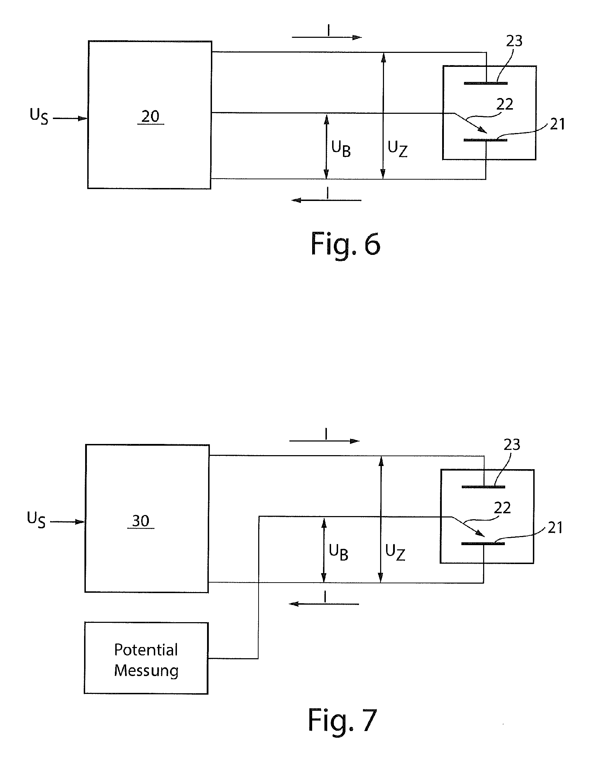

Die Anordnung zur Durchführung eines potentiostatischen Verfahrens zum Messen, Abscheiden oder Auflösen ist in **Figur 6** dargestellt. Die Anordnung umfasst mindestens einem Potentiostaten 20, mindestens eine Arbeits- 21, mindestens eine Referenz- 22 und mindestens eine Gegenelektrode 23. Es wird eine Führungsgröße Us vorgegeben, der die Regelgröße $U_B$ anhand der Stellgröße Uz nachgeführt wird. Dabei wird der Strom I an der Arbeitselektrode 21 beobachtet.

Die Anordnung zur Durchführung eines galvanostatischen Verfahrens, die in **Figur 7** dargestellt ist, umfasst mindestens einen Galvanostat 30, mindestens eine Arbeits- 21, mindestens eine Referenz- 22 und mindestens eine Gegenelektrode 23. Es wird eine Führungsgröße Us vorgegeben, der die Regelgröße I anhand der Stellgröße Uz nachgeführt wird. Dabei wird das Potential an der Referenzelektrode 22 beobachtet.

Im Rahmen der vorliegenden Erfindung sind Verfahren dann dynamisch, wenn sich bei potentiostatischen Verfahren die Führungsgröße Us an mindestens einem Punkt um mehr als 5 mV/s ändert oder sich bei galvanostatischen Verfahren die Beobachtungsgröße an mindestens einem Punkt um mehr als 5 mV/s ändert.

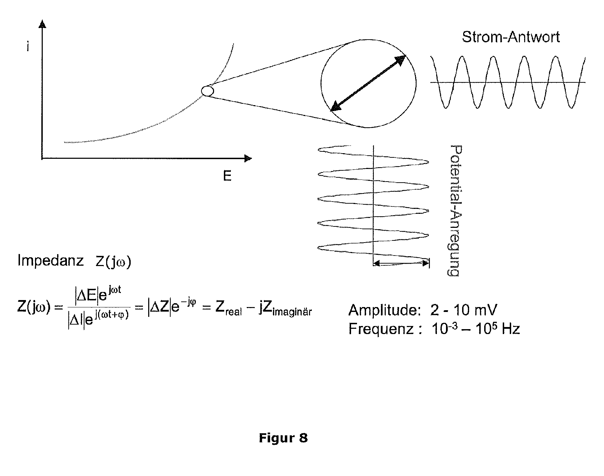

Impedanzspektroskopisch sind Verfahren dann, wenn bei potentiostatischen Verfahren an mindestens einem Arbeitspunkt die Spannung mit einer Frequenz von $10^{-3}$ Hz bis $10^5$ Hz und einer Amplitude bis etwa 50mV moduliert wird. Typischerweise wird eine Sinussignalform gewählt, es können aber auch andere Modulationen verwendet werden. Aus der Stromantwort und der Spannungsmodulation kann die Wechselstromimpedanz $Z(j\omega)$ berechnet werden (**Figur 8**).

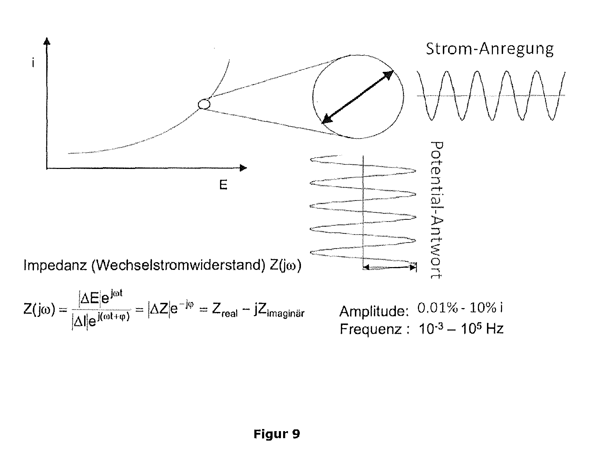

Impedanzspektroskopisch sind Verfahren dann, wenn bei galvanostatischen Verfahren an mindestens einem Arbeitspunkt der Strom mit einer Frequenz von $10^{-3}$ Hz bis $10^5$ Hz und einer Amplitude bis etwa 10 % des Stromes am Arbeitspunkt moduliert wird. Typischerweise wird eine Sinussignalform gewählt, es können aber auch andere Modulationen verwendet werden. Aus der Spannungsantwort und der Strommodulation kann die Wechselstromimpedanz $Z(j\omega)$ berechnet werden (**Figur 9**).

$$Z(j\omega) = \frac{|\Delta E|e^{j\omega t}}{|\Delta I|e^{j(\omega t+\varphi)}} = |\Delta Z|e^{-j\varphi} = Z_{real} - jZ_{imaginär}$$

Besonders bei potentiostatischen Anwendungen ist die Verzögerungszeit/Phasendrehung der Messschaltung entscheidend, um schwingungsfreie Messungen durchführen zu können. Daher ist es notwendig, die Verzögerungszeit/Phasendrehung, die durch die Referenzelektrode verursacht wird, so klein wie möglich zu halten, um exakte Messungen machen zu können. Dies ist noch wichtiger bei impedanzspektroskopischen Verfahren, da schon kleinste Phasenverschiebungen große Auswirkungen auf die Berechnung der Real- und Imaginärimpedanz haben können.

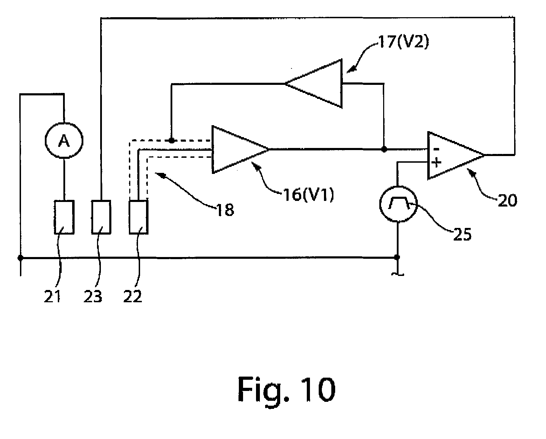

In **Fig. 10** ist eine potentiostatische Anordnung mit einer pH-Elektrode als Referenzelektrode 22, mit einem Impedanzwandler 16 (V1), einem Guardverstärker 17 (V2), einer Abschirmung (Guarding) 18, einem Potentiostat 20 und einem Funktionsgenerator 25 vereinfacht dargestellt.

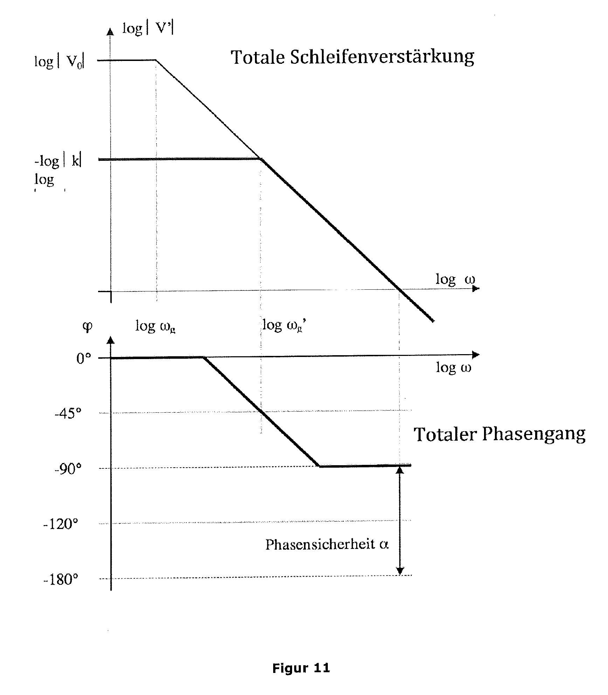

Es ist darauf zu achten, dass die gesamte Anordnung die Stabilitätskriterien einer Regelschlaufe erfüllt. Die Frequenzkompensation des Potentiostaten 20 sollte so eingestellt werden, dass noch genügend Phasensicherheit (mindestens 66° besser 90°) vorhanden ist, wie als Beispiel in **Fig. 11** dargestellt.

Die Erfindung wird nachfolgend anhand des Beispiels für eine praktische Anwendung beschrieben, nämlich die Bestimmung von organischen Additiven in galvanischen Bädern mittels CVS (cyclic voltammetry stripping). Es gibt mehrere Verfahren, wobei allen zugrunde liegt, dass in eine bestimmte Menge eines Grundelektrolyten eine wesentlich kleinere Menge der zu untersuchenden Probe zugegeben wird. Der pH-Wert der Probe entspricht damit in sehr guter Annäherung dem pH-Wert des Grundelektrolyten. Mit diesem Verfahren ist es möglich, die organischen Additive in der Probe zu bestimmen.

Deckschichtdiagramme werden zur Beurteilung der Qualität der Arbeitselektrode und des Zustands der Messzelle eingesetzt. Dafür wird typischerweise 1N Schwefelsäure eingesetzt.

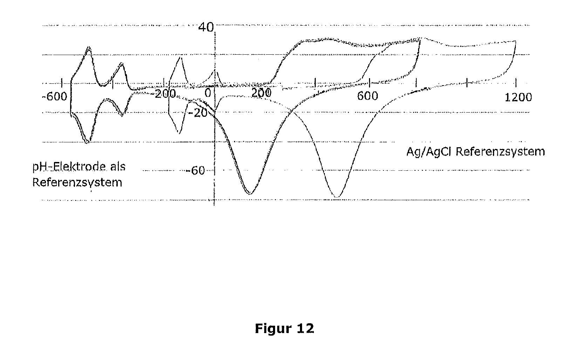

In **Fig. 12** ist ein Deckschichtdiagramm in 1 n $H_2SO_4$ mit 1 V/s und einer Plating 2 mm Arbeitselektrode dargestellt, das einmal mit einer üblichen Referenzelektrode Ag/AgCl und einmal mit einer pH-Glas-Elektrode als Referenzelektrode mit Impedanzwandler V1 und Guardschaltung V2 aufgenommen wurde. Die Vorschubgeschwindigkeit betrug bei beiden Messungen 1 V/s.

Dieses Beispiel zeigt, dass das Diagramm bei Verwendung einer pH-Elektrode um 385 mV in negative Richtung gegenüber einem Ag/AgCl-Referenzsystem verschoben ist. Dementsprechend wurden Start- und Endpotential CV Sweeps angepasst.

Es lassen sich problemlos Vorschubgeschwindigkeiten von 1V/s und mehr erreichen.

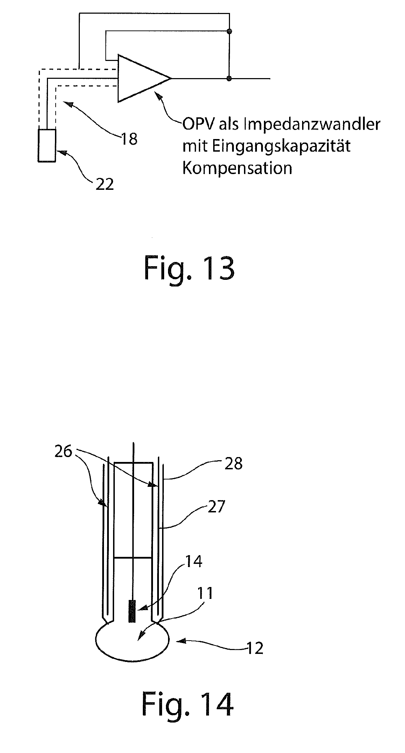

Die Verstärker 16 (V1) und 17 (V2) können auch zu einem Verstärker zusammengefasst werden, sofern dieser Verstärker die benötigten Eigenschaften von V1 und V2 besitzt. Dies ist in Abwandlung der Anordnung aus Figur 3 und ist als Beispiel in **Fig. 13** dargestellt.

Die pH-Elektroden können auch eine eigene Abschirmung 26 aufweisen, wie in **Fig. 14** vereinfacht dargestellt ist. Diese Abschirmung ist isoliert von der Außenhülle 27 der pH-Elektrode und darf keinen Kontakt mit der zu messenden Flüssigkeit haben. Typischerweise wird über die Abschirmung 26 ein weiteres Glasrohr 28 geschmolzen. Die Abschirmung 27 besteht aus einem elektrisch leitenden Material, das fest oder flüssig sein kann.

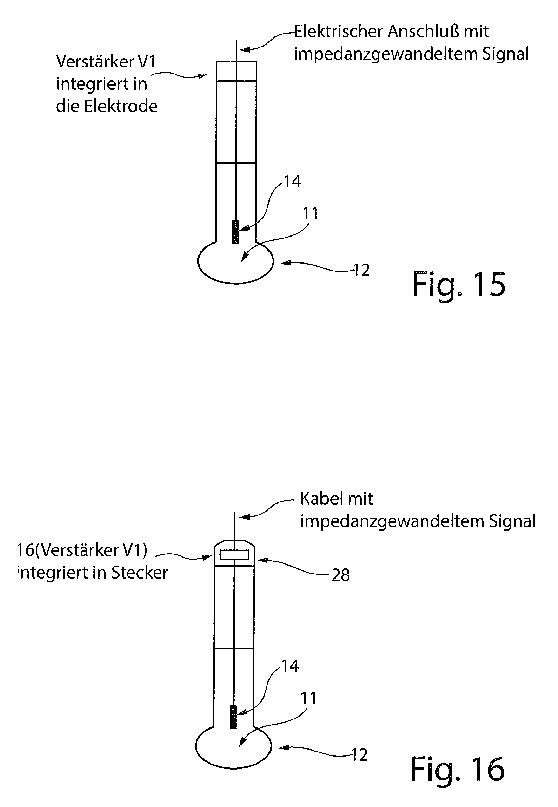

Sofern der Verstärker V1 direkt in die pH-Elektrode integriert ist, kann auf den Verstärker V2 verzichtet werden, sofern die pH-Elektrode keine Abschirmung aufweist. Für diese Anordnung, die in **Figur 15** dargestellt ist, ist ein mehradriges Kabel notwendig, da dem Verstärker V1 die Versorgungsspannung zugeführt werden muss. Zusätzlich ist eine Leitung für das Messsignal notwendig.

Es ist auch möglich, den Verstärker V1 in den Anschlussstecker 28 der pH-Elektrode zu integrieren. Weisen der Stecker 28 und die pH-Elektrode keine Abschirmung auf, kann auf den Verstärker V2 verzichtet werden. Diese Anordnung ist in **Fig. 16** vereinfacht dargestellt. Auch hier ist es notwendig, dem Verstärker 16 (V1) die Versorgungsspannung über das Kabel zuzuführen.

## Patentansprüche

1. Verwendung eines Referenzsystems für elektrochemische potentiostatische oder galvanostatische Analyse- und Abscheideverfahren, in welchen Analyse- oder Abscheideverfahren wenigstens eine Arbeitselektrode (21), eine Gegenelektrode (23) und eine Referenzelektrode (22) eingesetzt wird und die Referenzelektrode (22) eine pH-Elektrode (10) ist, die eine undurchlässige Membran (12) aufweist,
   wobei ein Eingangsverstärker V1 (16) für die pH-Elektrode (10) mit einer hohen Eingangsimpedanz vorgesehen ist,
   **dadurch gekennzeichnet,**
   **dass** die Grenzfrequenz des Eingangsverstärkers V1 (16) mehr als 1 MHz beträgt und:

   i) das Signal der pH-Elektrode (10) über ein Kabel dem Eingangsverstärker V1 (16) zuführt, und ein weiterer Verstärker V2 (17) vorgesehen ist, der eine Grenzfrequenz von wenigstens 1 MHz aufweist und eine kapazitive Last von mehr als 10 pF treiben kann und der weitere Verstärker V2 (17) dazu dient, als Guard-Verstärker die nachteiligen Effekte der parasitären Kapazität der Abschirmung des Kabels und des Messaufbaus zu kompensieren, oder
   ii) der Verstärker V1 (16) als Impedanzwandler in die pH-Elektrode (10) integriert ist, wobei ein weiterer Verstärker V2 (17) vorgesehen ist, der eine Grenzfrequenz von wenigstens 1 MHz aufweist und eine kapazitive Last von mehr als 10 pF treiben kann und der weitere Verstärker V2 (17) dazu dient, als Guard-Verstärker die nachteiligen Effekte der parasitären Kapazität der Abschirmung der pH-Elektrode zu kompensieren, in die die pH-Elektrode integriert ist, oder iii) der Verstärker V1 (16) als Impedanzwandler in den Stecker der pH-Elektrode integriert ist, wobei ein weiterer Verstärker V2 (17) vorgesehen ist, der eine Grenzfrequenz von wenigstens 1 MHz aufweist und eine kapazitive Last von mehr als 10 pF treiben kann und der weitere Verstärker V2 (17) dazu dient, als Guard-Verstärker die nachteiligen Effekte der parasitären Kapazität der Abschirmung der pH-Elektrode zu kompensieren, die in den Stecker der pH-Elektrode integriert ist.

2. Verwendung nach Anspruch 1, **dadurch gekennzeichnet, dass** die pH-Elektrode eine Glaselektrode, (10) oder eine Emaille-Elektrode ist.

3. Verwendung nach einem der vorangegangenen Ansprüche, **dadurch gekennzeichnet, dass** die Eingangsimpedanz des Eingangsverstärkers V1 (16) größer als $10^{11}\,\Omega$ und vorzugsweise größer als $10^{12}\,\Omega$ ist.

4. Verwendung nach einem der vorangegangenen Ansprüche, **dadurch gekennzeichnet, dass** der Eingangsstrom des Eingangsverstärkers V1 (16) weniger als 10 pA, vorzugsweise weniger als 1 pA und besonders bevorzugt weniger als 200 fA beträgt.

5. Verwendung nach einem der vorangegangenen Ansprüche, **dadurch gekennzeichnet, dass** die Grenzfrequenz des Eingangsverstärkers V1 (16) mehr als 3,5 MHz und besonders bevorzugt mehr als 25 MHz beträgt.

6. Verwendung nach einem der vorangegangenen Ansprüche, **dadurch gekennzeichnet, dass** der weitere Verstärker V2 (17) eine Grenzfrequenz von wenigstens 3,5 MHz und besonders bevorzugt wenigstens 15 MHz aufweist.

7. Verwendung nach einem der vorangegangenen Ansprüche, **dadurch gekennzeichnet, dass** der weitere Verstärker V2 (17) eine kapazitive Last von mehr als 100 pF und besonders bevorzugt von mehr als 1 nF treiben kann.

8. Verwendung nach einem der Ansprüche 1 bis 6, **dadurch gekennzeichnet, dass** der Eingangsverstärker V1 und der weitere Verstärker V2 in einem Verstärker realisiert werden.

9. Verwendung eines Referenzsystems nach einem der Ansprüche 1 bis 8 in dynamischen oder impedanzspektroskopischen, Verfahren.

10. Verwendung eines Referenzsystems nach einem der Ansprüche 1 bis 9 in der Halbleiterindustrie und der Leiterplattenfertigung.

11. Verwendung nach einem der Ansprüche 1 bis 10 in Beschichtungsverfahren mit Wechseln in den Beschichtungsverfahren, die unterhalb von 200 ms, vorzugsweise unterhalb von 100 ms, liegen.

**Claims**

1. Use of a reference system for electrochemical potentiostatic or galvanostatic analysis and deposition methods, in which at least one working electrode (21), one mating electrode (23) and one reference electrode (22) are used and the reference electrode (22) is a pH electrode (10) which comprises an impermeable membrane (12), wherein an input amplifier V1 (16) for the pH electrode (10) having a high input impedance is provided, **characterized in that** the cutoff frequency of the input amplifier V1 (16) is more than 1 MHz and:

i) the signal of the pH electrode (10) is delivered to the input amplifier V1 (16) via a cable and a further amplifier V2 (17) is provided, which has a cutoff frequency of at least 1 MHz and be capable of driving a capacitive load of more than 10 pF and the further amplifier V2 (17) is used as a guard amplifier to compensate for the detrimental effects of the stray capacitance of the guarding of the cable and of the measurement layout, or
ii) the amplifier V1 (16) is integrated as an impedance converter into the pH electrode (10), a further amplifier V2 (17) being provided, which has a cutoff frequency of at least 1 MHz and be capable of driving a capacitive load of more than 10 pF and the further amplifier V2 (17) is used as a guard amplifier to compensate for the detrimental effects of the stray capacitance of the guarding of the pH electrode, into which the pH electrode is integrated, or
iii) the amplifier V1 (16) is integrated as an impedance converter into the jack of the pH electrode, a further amplifier V2 (17) being provided, which has a cutoff frequency of at least 1 MHz and be capable of driving a capacitive load of more than 10 pF and the further amplifier V2 (17) is used as a guard amplifier to compensate for the detrimental effects of the stray capacitance of the guarding of the pH electrode, which is integrated into the jack of the pH electrode.

2. The use as claimed in claim 1, **characterized in that** the pH electrode is a glass electrode (10) or an enamel electrode.

3. The use as claimed in one of the preceding claims, **characterized in that** the input impedance of the input amplifier V1 (16) is more than $10^{11}$ $\Omega$ and preferably more than $10^{12}$ $\Omega$.

4. The use as claimed in one of the preceding claims, **characterized in that** the input current of the input amplifier V1 (16) is less than 10 pA, preferably less than 1 pA, and particularly preferably less than 200 fA.

5. The use as claimed in one of the preceding claims, **characterized in that** the cutoff frequency of the input amplifier V1 (16) is more than 3.5 MHz, and particularly preferably more than 25 MHz.

6. The use as claimed in one of the preceding claims, **characterized in that** the further amplifier V2 (17) has a cutoff frequency of at least 3.5 MHz, and particularly preferably at least 15 MHz.

7. The use as claimed in one of the preceding claims, **characterized in that** the further amplifier V2 (17) can drive a capacitive load of more than 100 pF, and particularly preferably more than 1 nF.

8. The use as claimed in one claims 1 to 6, **characterized in that** the input amplifier V1 as well as the further amplifier V2 are realized in one amplifier.

9. The use of a reference system as claimed in one of claims 1 to 8 in dynamic or impedance-spectroscopic methods.

10. The use of a reference system as claimed in one of claims 1 to 9 in the semiconductor industry and in printed circuit board manufacture.

11. The use as claimed in one of claims 1 to 10 in coating methods with changes in the coating methods shorter than 200 ms, preferably shorter than 100 ms.


**Revendications**

1. Utilisation d'un système de référence pour des procédés d'analyse et de séparation électrochimiques potentiostatiques ou galvanostatiques dans lesquels les procédés d'analyse ou de séparation utilisent au moins une électrode de travail (21), une contre-électrode (23) et une électrode de référence (22) et dans lesquels l'électrode de référence (22) est une électrode à pH (10) qui présente une membrane (12) imperméable, un amplificateur d'entrée V1 (16) ayant une haute impédance d'entrée étant prévu pour l'électrode à pH (10), **caractérisée en ce que** la fréquence de coupure de l'amplificateur d'entrée V1 (16) est supérieure à 1 MHz et **en ce que**

    i) le signal de l'électrode à pH (10) est amené à l'amplificateur d'entrée V1 (16) par l'intermédiaire d'un câble et **en ce qu'**il est prévu un autre amplificateur V2 (17) qui présente une fréquence de coupure d'au moins 1 MHz et peut alimenter une charge capacitive de plus de 10 pF et **en ce que** l'autre amplificateur V2 (17) sert en tant qu'amplificateur Guard à compenser les effets défavorables de la capacité parasitaire du blindage du câble et de la structure de mesure, ou **en ce que**
    ii) l'amplificateur V1 (16) est intégré en tant que transformateur d'impédance dans l'électrode à pH (10), un autre amplificateur V2 (17) étant prévu, lequel présente une fréquence de coupure d'au moins 1 MHz et peut alimenter une charge capacitive de plus de 10 pF et **en ce que** l'autre amplificateur V2 (17) sert en tant qu'amplificateur Guard à compenser les effets défavorables de la capacité parasitaire du blindage de l'électrode à pH dans lequel est intégrée l'électrode à pH, ou **en ce que**
    iii) l'amplificateur V1 (16) est intégré en tant que transformateur d'impédance dans la fiche de l'électrode à pH, un autre amplificateur V2 (17) étant prévu, lequel présente une fréquence de coupure d'au moins 1 MHz et peut alimenter une charge capacitive de plus de 10 pF et **en ce que** l'autre amplificateur V2 (17) sert en tant qu'amplificateur Guard à compenser les effets défavorables de la capacité parasitaire du blindage de l'électrode à pH qui est intégré dans la fiche de l'électrode à pH.

**2.** Utilisation selon la revendication 1, **caractérisée en ce que** l'électrode à pH est une électrode de verre (10) ou une électrode en émail.

**3.** Utilisation selon l'une quelconque des revendications précédentes, **caractérisée en ce que** l'impédance d'entrée de l'amplificateur d'entrée V1 (16) est supérieure à $10^{11}$ $\Omega$ et, de préférence, supérieure à $10^{12}$ $\Omega$.

**4.** Utilisation selon l'une quelconque des revendications précédentes, **caractérisée en ce que** le courant d'entrée de l'amplificateur d'entrée V1 (16) est inférieur à 10 pA et, de préférence, inférieur à 1 pA et, de manière privilégiée, inférieur à 200 fA.

**5.** Utilisation selon l'une quelconque des revendications précédentes, **caractérisée en ce que** la fréquence de coupure de l'amplificateur d'entrée V1 (16) est supérieure à 3,5 MHz et, de manière privilégiée, supérieure à 25 MHz.

**6.** Utilisation selon l'une quelconque des revendications précédentes, **caractérisée en ce que** l'autre amplificateur d'entrée V2 (17) présente une fréquence de coupure d'au moins 3,5 MHz et, de manière privilégiée, d'au moins 15 MHz.

**7.** Utilisation selon l'une quelconque des revendications précédentes, **caractérisée en ce que** l'autre amplificateur d'entrée V2 (17) peut alimenter une charge capacitive de plus de 100 pF et, de manière privilégiée, de plus de 1 nF.

**8.** Utilisation selon l'une quelconque des revendications 1 à 6, **caractérisée en ce que** l'amplificateur d'entrée V1 et l'autre amplificateur V2 sont réalisés en un seul amplificateur.

**9.** Utilisation d'un système de référence selon l'une quelconque des revendications 1 à 8 dans des procédés dynamiques ou par spectroscopie d'impédance.

**10.** Utilisation d'un système de référence selon l'une quelconque des revendications 1 à 9 dans l'industrie des semiconducteurs et dans la fabrication de circuits imprimés.

**11.** Utilisation selon l'une quelconque des revendications 1 à 10 dans des procédés de revêtement avec des changements dans les procédés de revêtement qui se situent au-dessous de 200 ms, de préférence au-dessous de 100 ms.

Fig. 1

Fig. 3

**Figur 2**

Figur 4

**Figur 5**

Fig. 6

Fig. 7

Strom-Antwort

Potential-Anregung

Impedanz $Z(j\omega)$

$$Z(j\omega) = \frac{|\Delta E|e^{j\omega t}}{|\Delta I|e^{j(\omega t+\varphi)}} = |\Delta Z|e^{-j\varphi} = Z_{real} - jZ_{imaginär}$$

Amplitude: 2 - 10 mV
Frequenz : $10^{-3} - 10^{5}$ Hz

**Figur 8**

Impedanz (Wechselstromwiderstand) Z(jω)

$$Z(j\omega) = \frac{|\Delta E|e^{j\omega t}}{|\Delta I|e^{j(\omega t+\varphi)}} = |\Delta Z|e^{-j\varphi} = Z_{real} - jZ_{imaginär}$$

Strom-Anregung

Potential-Antwort

Amplitude: 0.01% - 10% i
Frequenz : $10^{-3} - 10^5$ Hz

**Figur 9**

Fig. 10

Figur 11

**Figur 12**

OPV als Impedanzwandler
mit Eingangskapazität
Kompensation

18

22

Fig. 13

26

28

27

14

11

12

Fig. 14

Verstärker V1
integriert in
die Elektrode

Elektrischer Anschluß mit
impedanzgewandeltem Signal

14

11

12

**Fig. 15**

Kabel mit
impedanzgewandeltem Signal

16(Verstärker V1)
integriert in Stecker

28

14

11

12

**Fig. 16**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19748052 A1
- WO 2012019980 A1
- EP 1206012 A1
- DE 4329742 A1

**In der Beschreibung aufgeführte Nicht-Patentliteratur**

- **ALAN RICH.** AN-347 Application Notes. *Shielding and Guarding,* 01. Januar 1983, 1-6
- *LMP7721 3 Femtoampere Input Bias Current Precision Amplifier,* 14. Marz 2008